# EUROPEAN PATENT SPECIFICATION

(11) **EP 4 431 448 B1**
(45) Date of publication and mention of the grant of the patent: **13.05.2026**
(21) Application number: 23192001.8
(22) Date of filing: 17.08.2023
(51) Int. Cl.: B81B 3/00, G01P 15/097, G01P 15/125

(54) **SENSOR AND ELECTRONIC DEVICE**
SENSOR UND ELEKTRONISCHE VORRICHTUNG
CAPTEUR ET DISPOSITIF ÉLECTRONIQUE

(30) Priority: 13.03.2023 JP 2023038506
(43) Date of publication of application: 18.09.2024
(73) Proprietor: Kabushiki Kaisha Toshiba, Minato-ku Tokyo (JP)
(72) Inventor: MASUNISHI, Kei, Tokyo (JP); OGAWA, Etsuji, Tokyo (JP); TOMIZAWA, Yasushi, Tokyo (JP); MIYAZAKI, Fumito, Tokyo (JP); ONO, Daiki, Tokyo (JP); UCHIDA, Kengo, Tokyo (JP); OGAWA, Jumpei, Tokyo (JP); ISHIBASHI, Fumitaka, Tokyo (JP); MURASE, Hideaki, Tokyo (JP)
(74) Representative: Marks & Clerk LLP

(56) References cited:
- US-A1- 2002 152 812
- US-A1- 2016 139 170
- US-A1- 2020 064 367
- US-A1- 2023 062 441

## Description

### FIELD

Embodiments described herein relate generally to a sensor and an electronic device.

### BACKGROUND

For example, there is a sensor using a MEMS structure. It is desired to improve the characteristics of the sensor.

US 2002/152812 relates to a flat monolithic accelerometer detector that comprises a body having a base and two measurement cells each having a seismic mass connected to the base via a joint enabling the mass to turn about an axis perpendicular to a sensing axis of the detector and each having a vibrating beam force sensor connecting the mass to the base, the cells being placed in such a manner that when one of the beams is subjected to a traction force due to an acceleration along the sensing axis, the other beam is subjected to a compression force of the same magnitude, the cells being disposed in opposite directions and symmetrically about an axis of the base for fixing to a support whose acceleration is to be measured. Each beam is constituted by at least two parallel blades that are at different distances from the joint, with the two blades in a given cell being connected to the seismic mass of that cell via a common hinge.

US 2023/062441 relates to a sensor including a base, a first support portion fixed to the base, and a first movable portion supported by the first support portion. The first movable portion includes first and second movable base portions, a connecting base portion, first and second movable beams, and first and second movable conductive portions. The first movable beam includes a first beam end portion, a first beam other end portion, and a first beam intermediate portion. The second movable beam includes a second beam end portion, a second beam other end portion, and a second beam intermediate portion. The first movable conductive portion includes a first crossing conductive portion, a first extending conductive portion, and a first other extending conductive portion. The second movable conductive portion includes a second crossing conductive portion, a second extending conductive portion, and a second other extending conductive portion. US 2016/139170 A1 discloses an acceleration sensor comprising a proof mass, a support base configured to support the proof mass, wherein the proof mass is configured to displace in response to an acceleration of the device, a flexure configured to flexibly connect the proof mass to the support base; and a strain-monitoring device configured to measure an amount of strain on the support base. The strain-monitoring device comprises two double-ended tuning forks (DETF).

### BRIEF DESCRIPTION OF THE DRAWINGS

FIG. 1 is a schematic plan view illustrating a sensor in accordance with an example useful for understanding the invention;
FIGS. 2A to 2D are schematic cross-sectional views illustrating the sensor in accordance with an example useful for understanding the invention;
FIG. 3 is a schematic plan view illustrating a part of the sensor in accordance with an example useful for understanding the invention;
FIG. 4 is a schematic plan view illustrating a sensor in accordance with an example useful for understanding the invention;
FIGS. 5A and 5B are schematic plan views illustrating a part of the sensor in accordance with an example useful for understanding the invention;
FIG. 6 is a schematic plan view illustrating a sensor in accordance with an example useful for understanding the invention;
FIG. 7 is a schematic plan view illustrating a sensor in accordance with an example useful for understanding the invention;
FIG. 8 is a schematic plan view illustrating a sensor according to the first embodiment of the invention;
FIG. 9 is a schematic plan view illustrating a sensor according to the first embodiment;
FIG. 10 is a schematic plan view illustrating a sensor according to the first embodiment;
FIG. 11 is a schematic plan view illustrating a sensor according to the first embodiment;
FIG. 12 is a schematic plan view illustrating a sensor in accordance with an example useful for understanding the invention;
FIG. 13 is a schematic plan view illustrating a sensor in accordance with an example useful for understanding the invention;
FIG. 14 is a schematic plan view illustrating a sensor in accordance with an example useful for understanding the invention;
FIG. 15 is a schematic plan view illustrating a sensor in accordance with an example useful for understanding the invention;
FIG. 16 is a schematic diagram illustrating an electronic device according to a second embodiment of the invention;
FIGS. 17A to 17H are schematic diagrams illustrating applications of the electronic device according to the embodiment; and
FIGS. 18A and 18B are schematic diagrams illustrating applications of the sensor according to the embodiment.

### DETAILED DESCRIPTION

According to embodiment first aspect, a sensor is provided as recited in claim 1. In a second aspect, an electronic device is provided as recited in claim 8.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### First Embodiment

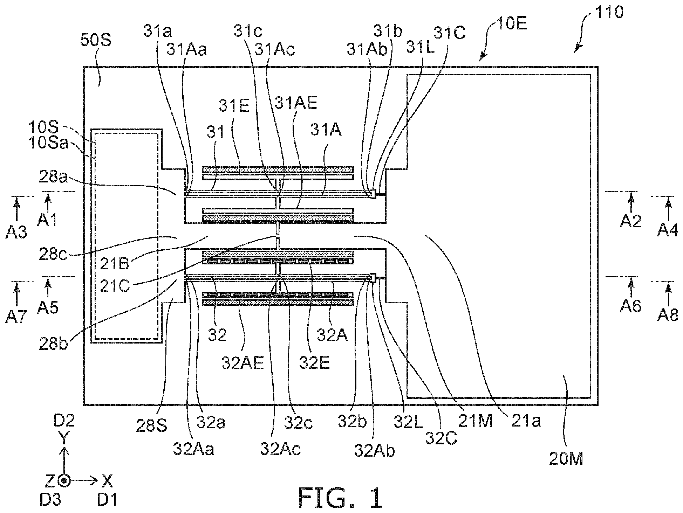

FIG. 1 is a schematic plan view illustrating a sensor in accordance with an example useful for understanding the invention.

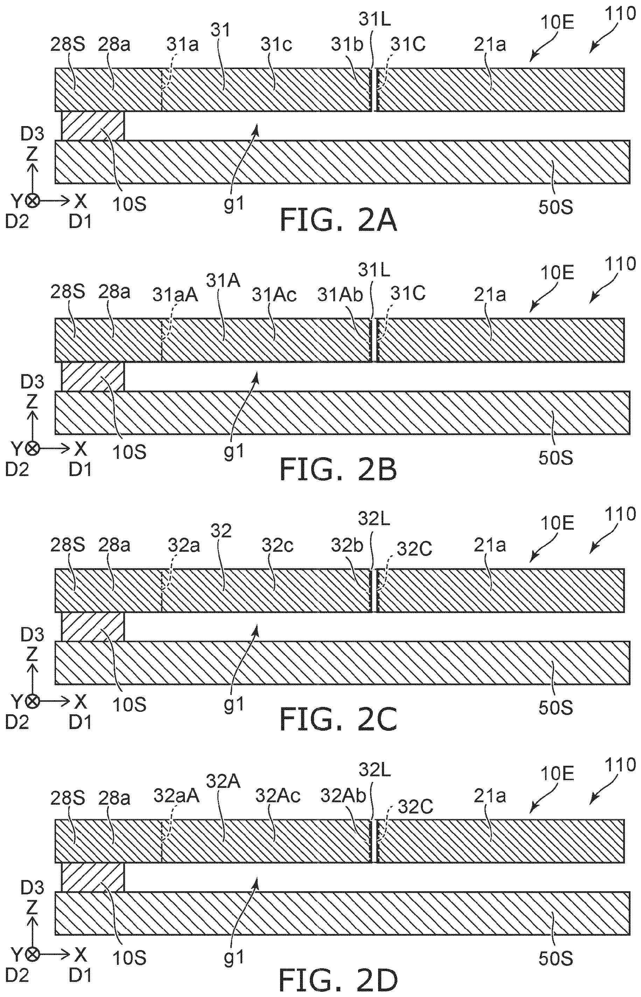

FIGS. 2A to 2D are schematic cross-sectional views illustrating the sensor of FIG. 1.

FIG. 2A is a cross-sectional view taken along the line A1-A2 in FIG. 1. FIG. 2B is a cross-sectional view taken along the line A3-A4 of FIG. 1. FIG. 2C is a cross-sectional view taken along the line A5-A6 of FIG. 1. FIG. 2D is a cross-sectional view taken along the line A7-A8 of FIG. 1.

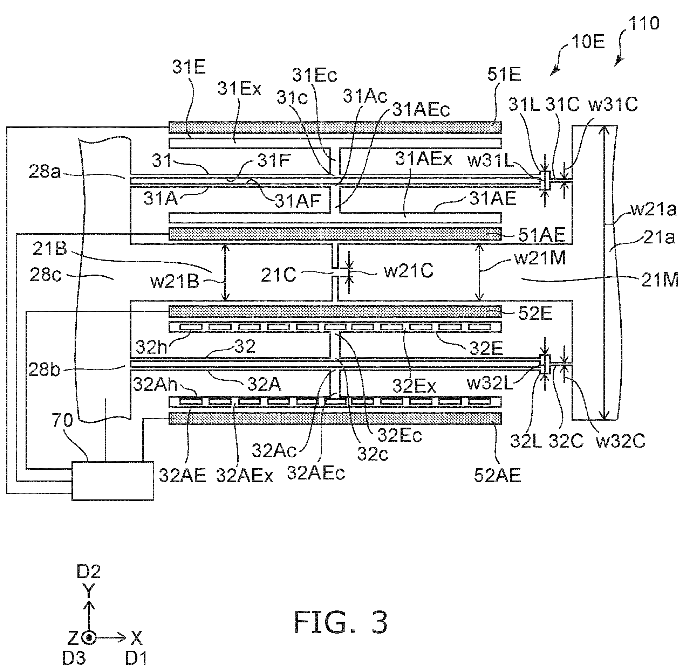

FIG. 3 is a schematic plan view illustrating a part of the sensor of FIG. 1.

As shown in FIG. 1 and FIGS. 2A to 2D, a sensor 110 includes an element section 10E. The element section 10E includes a first beam 31, a first opposing beam 31A, a support portion 28S, a first linking portion 31L, and a first connecting portion 31C.

The first beam 31 includes a first portion 31a and a first other portion 31b. A direction from the first portion 31a to the first other portion 31b is along a first direction D1.

A second direction D2 from the first opposing beam 31A to the first beam 31 crosses the first direction D1. The second direction D2 may be perpendicular to the first direction D1. The first opposing beam 31A includes a first opposing portion 31Aa and a first other opposing portion 31Ab. A direction from the first opposing portion 31Aa to the first other opposing portion 31Ab is along the first direction D1.

The support portion 28S includes a first support region 28a. The first support region 28a is connected to, for example, the first portion 31a and the first opposing portion 31Aa.

The first linking portion 31L is connected to the first other portion 31b and the first other opposing portion 31Ab. The first connecting portion 31C is connected to the first linking portion 31L. The first linking portion 31L is provided between the first beam 31 and the first connecting portion 31C and between the first opposing beam 31A and the first connecting portion 31C.

As shown in FIG. 3, a width (length) along the second direction D2 of the first connecting portion 31C is defined as a first connecting portion width w31C. A width (length) along the second direction D2 of the first linking portion 31L is defined as a first linking portion width w31L. As shown in FIG. 3, the first connecting portion width w31C is narrower than the first linking portion width w31L. For example, the first connecting portion 31C deforms more easily than the first linking portion 31L.

In the example of FIG. 3, one of each of the two beams (the first portion 31a and the first opposing portion 31Aa) is connected to the first support region 28a. The other one of the two beams (the first other portion 31b and the first other opposing portion 31Ab) is connected to the first connecting portion 31C being easily deformable via the first linking portion 31L.

By the first linking portion 31L and the first connecting portion 31C, two beams are easily deformed uniformly, for example. By providing the first connecting portion 31C being easily deformable, the received force is efficiently transmitted to the two beams. For example, it is easy to obtain high sensitivity. For example, it becomes easier to obtain a large scale-factor. For example, it is easy to obtain a highly linear scale-factor. It becomes easier to obtain highly stable vibration (resonance).

Meanwhile, the other ends of the two beams are connected to the first support region 28a. For example, no deformable connection is provided between the other ends of the two beams and the first support region 28a. For example, the other ends of the two beams are directly connected with the first support region 28a. Thereby, for example, stable resonance characteristics can be obtained. For example, a high Q value is obtained at the portion where the two beams and the first support region 28a are connected.

As described above, in the sensor 110, the configuration of one end of the two beams and the configuration of the other end are asymmetrical. According to the example of FIG. 3, a high linearity scale-factor, a large scale-factor, and a high operational stability can be provided. A high Q value is obtained. According to the example, it is possible to provide a sensor whose characteristics can be improved.

In general, the configuration of one end of the two beams is the same as the configuration of the other end of the two beams. In the case where both ends of the two beams are each connected to a flexible connection via a linking portion, it is difficult to obtain a high Q value. In the case where both ends of the two beams are each directly connected to the support region, it is difficult to obtain a highly linear scale-factor.

As shown in FIG. 1 and FIGS. 2A-2D, the sensor 110 may include a base 50S and a first fixed portion 10S. The first fixed portion 10S is fixed to the base 50S. A third direction D3 from the base 50S to the first fixed portion 10S crosses a plane including the first direction D1 and the second direction D2.

The first direction D1 is defined as an X-axis direction. One direction perpendicular to the X-axis direction is defined as a Y-axis direction. A direction perpendicular to the X-axis direction and the Y-axis direction is defined as a Z-axis direction. The second direction D2 may be, for example, the Y-axis direction. The third direction D3 may be, for example, the Z-axis direction.

The first support region 28a is supported by the first fixed portion 10S. For example, the first fixed portion 10S includes a first fixed region 10Sa. The first support region 28a is supported by the first fixed region 10Sa.

As shown in FIGS. 2A to 2D, a first gap g1 is provided between the base 50S and the element section 10E.

The element section 10E includes a movable member 20M supported by the support portion 28S. The movable member 20M includes a first movable portion 21a. The first connecting portion 31C is connected to the first movable portion 21a.

For example, the movable member 20M (first movable portion 21a) is displaced according to a force (e.g., acceleration) being received. The displacement is efficiently transmitted to the first beam 31 and the first opposing beam 31A via the first connecting portion 31C and the first linking portion 31L. A stable deformation occurs in the two beams depending on the force being received. For example, the resonant frequencies of these beams are affected by the deformation (stress). By detecting the change in the resonance frequency, the force being received can be detected.

As shown in FIG. 3, the movable member 20M may include a first movable base portion 21B and a first movable connecting portion 21C. The first movable base portion 21B is supported by the support portion 28S. In this example, the first movable base portion 21B is supported by a third support region 28c of the support portion 28S. The first movable connecting portion 21C is provided between the first movable base portion 21B and the first movable portion 21a. The first movable connecting portion 21C connects the first movable portion 21a to the first movable base portion 21B.

As shown in FIG. 3, a width (length) of the first movable connecting portion 21C in a crossing direction (in this example, the second direction D2) crossing the direction (in this example, the first direction D1) from the first movable base portion 21B to the first movable connecting portion 21C is defined as a first movable connecting portion width w21C. A width (length) of the first movable base portion 21B in the crossing direction is defined as a first movable base portion width w21B. A width (length) of the first movable portion 21a in the crossing direction is defined as a first movable portion width w21a. The first movable connecting portion width w21C is narrower than the first movable base portion width w21B. The first movable connecting portion width w21C is narrower than the first movable portion width w21a.

In this example, the movable member 20M includes a first movable intermediate portion 21M provided between the first movable connecting portion 21C and the first movable portion 21a. In the second direction D2, the first opposing beam 31A is provided between the first movable intermediate portion 21M and the first beam 31. A width (length) of the first movable intermediate portion 21M in the crossing direction (in this example, the second direction D2) is defined as a first movable intermediate portion width w21M. The first movable connecting portion width w21C is narrower than the first movable intermediate portion width w21M. The first movable connecting portion 21C functions, for example, as a pivot portion. For example, the force is amplified by leverage action. For example, the first movable portion 21a is easily displaced.

As shown in FIG. 3, the first beam 31 further includes a first intermediate portion 31c between the first portion 31a and the first other portion 31b. The first opposing beam 31A further includes a first opposing intermediate portion 31Ac between the first opposing portion 31Aa and the first other opposing portion 31Ab. The element section 10E includes a first beam electrode 31E connected to the first intermediate portion 31c and a first opposing beam electrode 31AE connected to the first opposing intermediate portion 31Ac.

In this example, the first beam 31 is provided between the first opposing beam electrode 31AE and the first beam electrode 31E. The first opposing beam 31A is provided between the first opposing beam electrode 31AE and the first beam 31.

As shown in FIG. 3, in this example, the first beam electrode 31E includes a first extending portion 31Ex and a first extending connecting portion 31Ec. The first extending portion 31Ex extends along the first direction D1. The first extending connecting portion 31Ec connects the first extending portion 31Ex to the first intermediate portion 31c. The first extending portion 31Ex extends along the second direction D2.

As shown in FIG. 3, the first opposing beam electrode 31AE includes a first opposing extending portion 31AEx and a first opposing extending connecting portion 31AEc. The first opposing extending portion 31AEx extends along the first direction D1. The first opposing extending connecting portion 31AEc connects the first opposing extending portion 31AEx to the first opposing intermediate portion 31Ac. The first opposing extending connecting portion 31AEc extends along the second direction D2.

As shown in FIG. 3, the element section 10E may further include a first fixed electrode 51E and a first opposing fixed electrode 51AE fixed to the base 50S. The first fixed electrode 51E faces the first beam electrode 31E. The first opposing fixed electrode 51AE faces the first opposing beam electrode 31AE. A direction from the first fixed electrode 51E to the first beam electrode 31E is along the second direction D2. A direction from the first opposing fixed electrode 51AE to the first opposing beam electrode 31AE is along the second direction D2.

As shown in FIG. 3, a controller 70 may be provided. The controller 70 may be included in the sensor 110. The controller 70 may be provided separately from the sensor 110. The controller 70 is configured to, for example, apply a first AC signal between the first fixed electrode 51E and the first beam electrode 31E. The controller 70 is configured to detect, for example, a first signal generated between the first opposing fixed electrode 51AE and the first opposing beam electrode 31AE. The force (acceleration) being received can be detected by the first signal. In the example of FIG. 3, the position of the first beam 31 and the position of the first opposing beam 31A may be interchanged.

As shown in FIG. 3, the first beam 31 includes a first beam face 31F facing the first opposing beam 31A. The first opposing beam 31A includes a first opposing beam face 31AF facing the first beam 31. The first beam face 31F and the first opposing beam face 31AF extend along the first direction D1. The first beam face 31F and the first opposing beam face 31AF are flat, for example. Thereby, for example, the distance between the first beam 31 and the first opposing beam 31A can be appropriately shortened. For example, substantially the same stress tends to be applied to two beams. It becomes easier to obtain stable resonance characteristics.

As shown in FIG. 3, the element section 10E may further include a second beam 32, a second opposing beam 32A, a second linking portion 32L, and a second connecting portion 32C. The support portion 28S further includes a second support region 28b.

The second beam 32 includes a second portion 32a and a second other portion 32b. A direction from the second portion 32a to the second other portion 32b is along the first direction D1. The second opposing beam 32A includes a second opposing portion 32Aa and a second other opposing portion 32Ab. A direction from the second opposing portion 32Aa to the second other opposing portion 32Ab is along the first direction D1.

The second support region 28b is connected to the second portion 32a and the second opposing portion 32Aa. The second linking portion 32L is connected to the second other portion 32b and the second other opposing portion 32Ab. The second connecting portion 32C is connected to the second linking portion 32L. The second linking portion 32L is provided between the second beam 32 and the second connecting portion 32C and between the second opposing beam 32A and the second connecting portion 32C.

A second connecting portion width w32C along the second direction D2 of the second connecting portion 32C is narrower than a second linking portion width w32L along the second direction D2 of the second linking portion 32L. In this example, a direction from the second beam 32 to the first beam 31 is along the second direction D2.

In the portion including the second beam 32, the second opposing beam 32A, the second linking portion 32L, and the second connecting portion 32C also, a high linear scale-factor, a large scale-factor, and high operation stability can be obtained, in the same way as the portion including the first beam 31, the first opposing beam 31A, the first linking portion 31L, and the first connecting portion 31C. High Q value is obtained.

As shown in FIG. 3, the second beam 32 further includes a second intermediate portion 32c between the second portion 32a and the second other portion 32b. The second opposing beam 32A further includes a second opposing intermediate portion 32Ac between the second opposing portion 32Aa and the second other opposing portion 32Ab.

The element section 10E includes a second beam electrode 32E connected to the second intermediate portion 32c and a second opposing beam electrode 32AE connected to the second opposing intermediate portion 32Ac. For example, the second beam 32 is provided between the second opposing beam electrode 32AE and the second beam electrode 32E. For example, the second opposing beam 32A is provided between the second opposing beam electrode 32AE and the second beam 32.

As shown in FIG. 3, the second beam electrode 32E includes a second extending portion 32Ex and a second extending connecting portion 32Ec. The second extending portion 32Ex extends along the first direction D1. The second extending connecting portion 32Ec connects the second extending portion 32Ex to the second intermediate portion 32c. The second extending connecting portion 32Ec extends along the second direction D2.

The second opposing beam electrode 32AE includes a second opposing extending portion 32AEx and a second opposing extending connecting portion 32AEc. The second opposing extending portion 32AEx extends along the first direction D1. The second opposing extending connecting portion 32AEc connects the second opposing extending portion 32AEx to the second opposing intermediate portion 32Ac. The second opposing extending connecting portion 32AEc extends along the second direction D2.

As shown in FIG. 3, the element section 10E may further include a second fixed electrode 52E and a second opposing fixed electrode 52AE fixed to the base 50S. The second fixed electrode 52E faces the second beam electrode 32E. The second opposing fixed electrode 52AE faces the second opposing beam electrode 32AE. A direction from the second fixed electrode 52E to the second beam electrode 32E is along the second direction D2. A direction from the second opposing fixed electrode 52AE to the second opposing beam electrode 32AE is along the second direction D2.

The controller 70 is configured to, for example, apply a second AC signal between the second fixed electrode 52E and the second beam electrode 32E. The controller 70 is configured to detect, for example, a second signal generated between the second opposing fixed electrode 52AE and the second opposing beam electrode 32AE. The force (acceleration) being received can be detected by the second signal. In the example of FIG. 3, the position of the second beam 32 and the position of the second opposing beam 32A may be interchanged.

The controller 70 may output a signal including a difference between the first signal and the second signal. For example, by a signal including the difference in resonant frequencies, detection with higher sensitivity and with higher accuracy can be possible.

As shown in FIG. 3, the second beam electrode 32E may include a second hole 32h. The second opposing beam electrode 32AE may include a second opposing hole 32Ah. The second beam electrode 32E may have a configuration different from a configuration of the first beam electrode 31E. The second opposing beam electrode 32AE may have a configuration different from a configuration of the first opposing beam electrode 31AE. Asymmetric configurations may also be applied. For example, it becomes easier to obtain detection with a wide dynamic range.

For example, the first beam electrode 31E and the second beam electrode 32E may satisfy at least one of a first condition, a second condition, a third condition, a fourth condition, a fifth condition, a sixth condition, a seventh condition or an eighth condition.

In the first condition, a second mass of the second beam electrode 32E is different from a first mass of the first beam electrode 31E. In the second condition, a second thickness along the third direction D3 of the second beam electrode 32E is different from a first thickness along the third direction D3 of the first beam electrode 31E. In the third condition, at least a part of a second material included in the second beam electrode 32E is different from at least a part of a first material included in the first beam electrode 31E.

In the fourth condition, a second size of the second hole 32h included in the second beam electrode 32E is different from a first size of the first hole included in the first beam electrode 31E. Alternatively, the first beam electrode 31E does not include the first hole. In the fifth condition, a second density of the second holes 32h is different from a first density of the first holes. In the sixth condition, a second number of second holes 32h is different from a first number of first holes. In the seventh condition, a second shape of the second hole 32h is different from a first shape of the first hole. In the eighth condition, a second layer structure of the second beam electrode 32E is different from a first layer structure of the first beam electrode 31E.

The first to eighth conditions as described above may be applied to the first opposing beam electrode 31AE and the second opposing beam electrode 32AE.

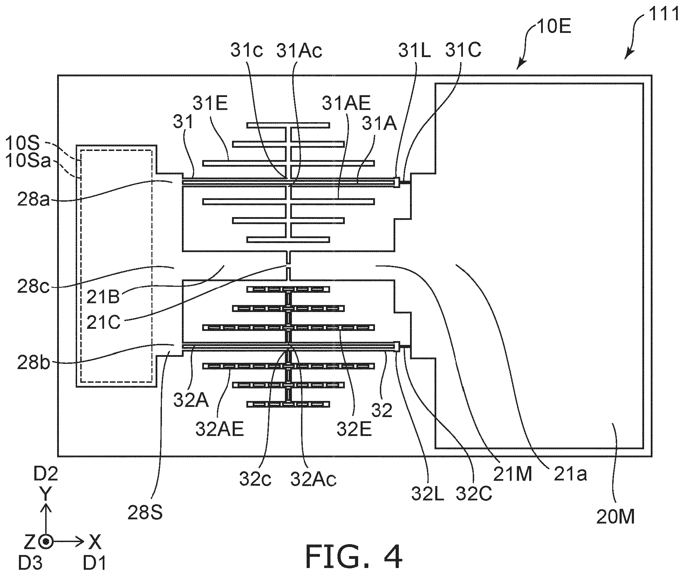

FIG. 4 is a schematic plan view illustrating a sensor in accordance with an example useful for understanding the invention.

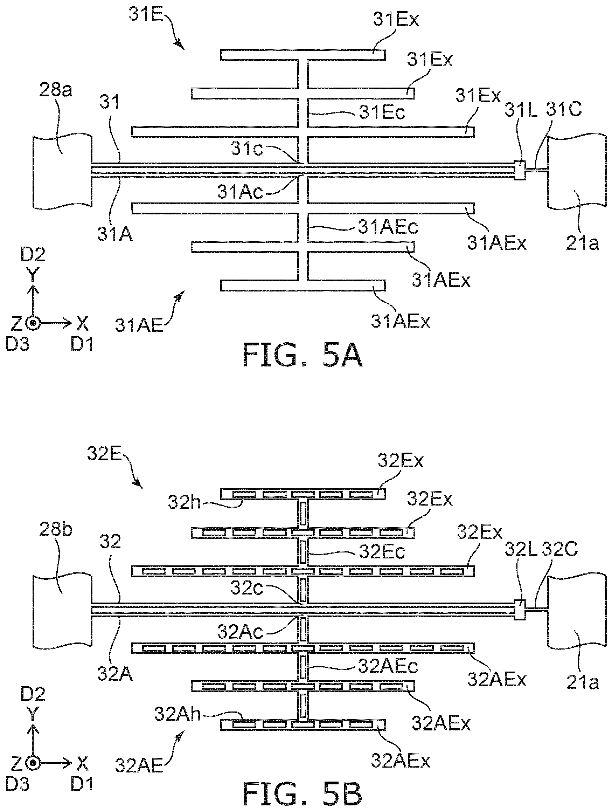

FIGS. 5A and 5B are schematic plan views illustrating a part of the sensor of FIG. 4.

As shown in FIG. 4, in a sensor 111 the configurations of the first beam electrode 31E and the first opposing beam electrode 31AE are different from those in the sensor 110. Other configurations of the sensor 111 may be the same as the configuration of the sensor 110.

As shown in FIG. 5A, in the sensor 111, the first beam electrode 31E includes a plurality of first extending portions 31Ex. One of the plurality of first extending portions 31Ex is provided between the first beam 31 and another one of the plurality of first extending portions 31Ex. A length of the one of the first extending portions 31Ex along the first direction D1 is longer than a length of the other one of the first extending portions 31Ex along the first direction D1.

As shown in FIG. 5A, in the sensor 111, the first opposing beam electrode 31AE includes a plurality of first opposing extending portions 31AEx. One of the plurality of first opposing extending portions 31AEx is provided between the first opposing beam 31A and another one of the plurality of first opposing extending portion 31AEx. A length of the one of the plurality of first opposing extending portions 31AEx along the first direction D1 is longer than a length of the other one of the plurality of first opposing extending portions 31AEx along the first direction D1.

With such a configuration, the area of the beam electrodes can be increased. Detection with higher sensitivity becomes possible.

As shown in FIG. 5B, the second beam electrode 32E includes a plurality of second extending portions 32Ex. One of the plurality of second extending portions 32Ex is provided between the second beam 32 and another one of the plurality of second extending portions 32Ex. A length of the one of the plurality of second extending portions 32Ex along the first direction D1 is longer than a length of the other one of the plurality of second extending portions 32Ex along the first direction D1.

As shown in FIG. 5B, the second opposing beam electrode 32AE includes a plurality of second opposing extending portions 32AEx. One of the plurality of second opposing extending portions 32AEx is provided between the second opposing beam 32A and another one of the plurality of second opposing extending portions 32AEx. A length of the one of the plurality of second opposing extending portions 32AEx along the first direction D1 is longer than a length of the other one of the plurality of second opposing extending portions 32AEx along the first direction D1.

In the sensor 111, the first beam electrode 31E and the second beam electrode 32E may satisfy at least one of the first to eighth conditions described above. The first opposing beam electrode 31AE and the second opposing beam electrode 32AE may satisfy at least one of the first to eighth conditions described above.

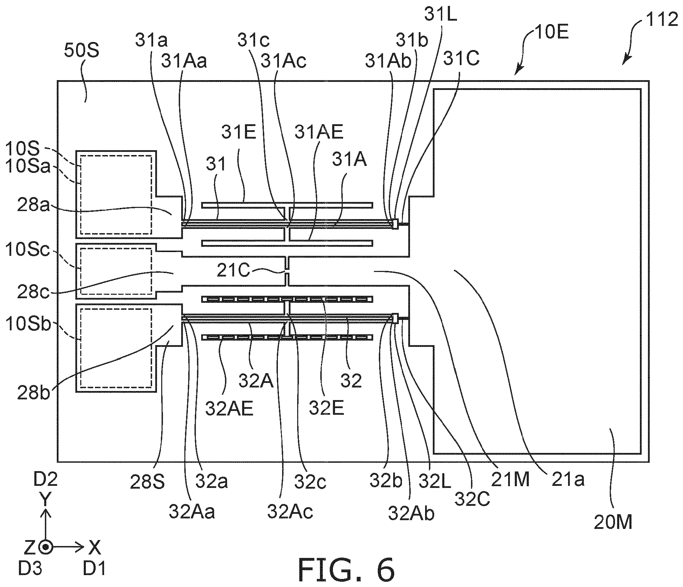

FIG. 6 is a schematic plan view illustrating a sensor in accordance with an example useful for understanding the invention.

As shown in FIG. 6, in a sensor 112, the first fixed portion 10S includes the first fixed region 10Sa, a second fixed region 10Sb, and a third fixed region 10Sc. Except for this, the configuration of the sensor 112 may be the same as the configuration of the sensor 110. In the sensor 112, the first support region 28a is supported by the first fixed region 10Sa. The second support region 28b is supported by the second fixed region 10Sb. The third support region 28c is supported by the third fixed region 10Sc.

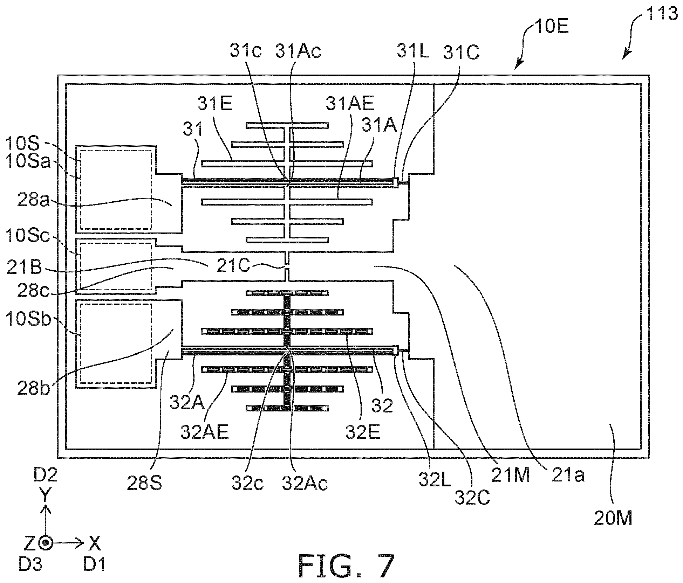

FIG. 7 is a schematic plan view illustrating a sensor in accordance with an example useful for understanding the invention.

As shown in FIG. 7, in a sensor 113 according to the embodiment, the first fixed portion 10S includes the first fixed region 10Sa, the second fixed region 10Sb, and the third fixed region 10Sc. Except for this, the configuration of the sensor 113 may be the same as the configuration of the sensor 111.

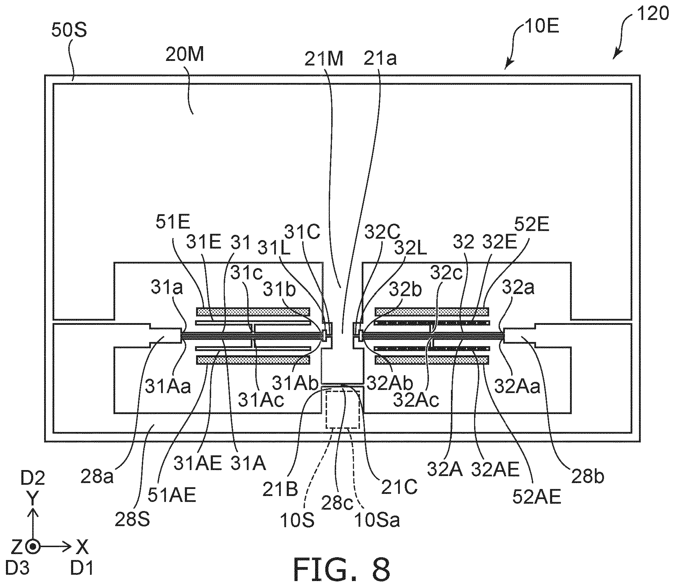

FIG. 8 is a schematic plan view illustrating a sensor according to the first embodiment.

As shown in FIG. 8, in a sensor 120 according to the embodiment, the element section 10E includes the first beam 31, the first opposing beam 31A, the first linking portion 31L, the first connecting portion 31C, the second beam 32, the second opposing beams 32A, the second linking portion 32L, and the second connecting portion 32C. In sensor 120, the relative positions of the first beam 31 and the second beam 32 are different from those in the sensor 110. Except for this, the configuration of the sensor 120 may be the same as the configuration of the sensor 110.

In the sensor 120, for example, the direction from the second beam 32 to the first beam 31 is along the first direction D1. For example, the first linking portion 31L is provide between the first support region 28a and the second support region 28b in the first direction D1. The second linking portion 32L is provided between the first linking portion 31L and the second support region 28b in the first direction D1. The sensor 120 also provides a highly linear scale-factor, a large scale-factor, and high operational stability. A high Q value is obtained. A sensor capable of improving characteristics can be provided. For example, the force is amplified by leverage action of the first movable connecting portion 21C.

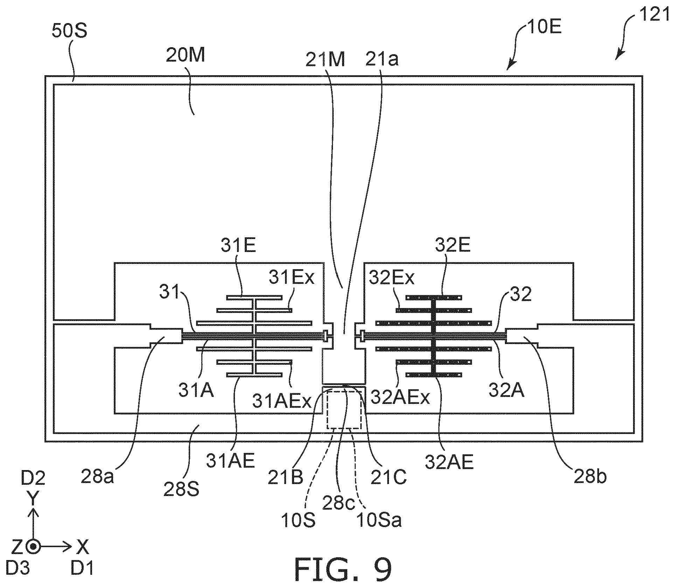

FIG. 9 is a schematic plan view illustrating a sensor according to the first embodiment.

As shown in FIG. 9, in a sensor 121 according to the embodiment, the plurality of first extending portions 31Ex, the plurality of first opposing extending portions 31AEx, the plurality of second extending portions 32Ex, and the plurality of second opposing extending portions 32AEx are provided. Except for this, the configuration of the sensor 121 may be the same as the configuration of the sensor 120.

The plurality of first extending portions 31Ex, the plurality of first opposing extending portions 31AEx, the plurality of second extending portions 32Ex, and the plurality of second opposing extending portions 32AEx may have, for example, the configuration described with respect to the sensor 111.

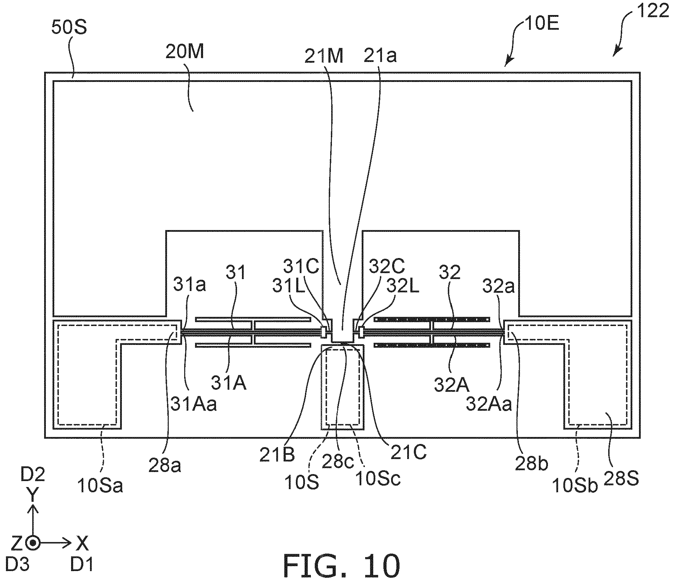

FIG. 10 is a schematic plan view illustrating a sensor according to the first embodiment.

As shown in FIG. 10, in a sensor 122 according to the embodiment, the first fixed portion 10S includes the first fixed region 10Sa, the second fixed region 10Sb, and the third fixed region 10Sc. Except for this, the configuration of the sensor 122 may be the same as the configuration of the sensor 120. In the sensor 122, the first support region 28a is supported by the first fixed region 10Sa. The second support region 28b is supported by the second fixed region 10Sb. The third support region 28c is supported by the third fixed region 10Sc.

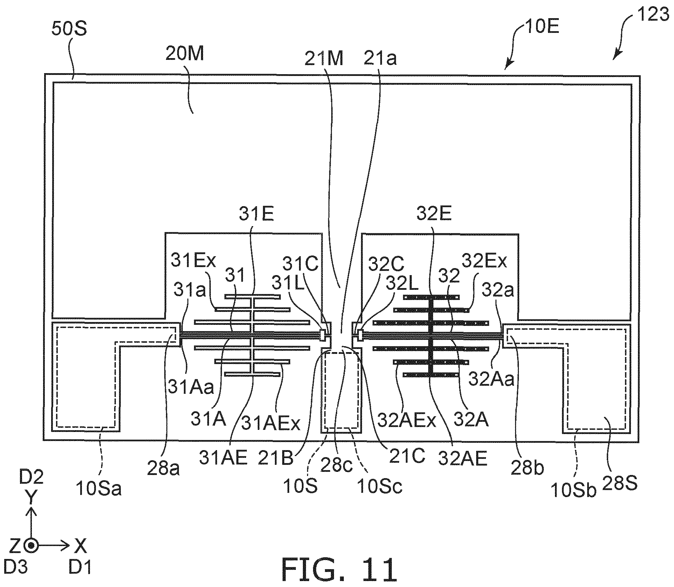

FIG. 11 is a schematic plan view illustrating a sensor according to the first embodiment.

As shown in FIG. 11, in a sensor 123 according to the embodiment, the first fixed portion 10S includes the first fixed region 10Sa, the second fixed region 10Sb, and the third fixed region 10Sc. Except for this, the configuration of the sensor 123 may be the same as the configuration of the sensor 121.

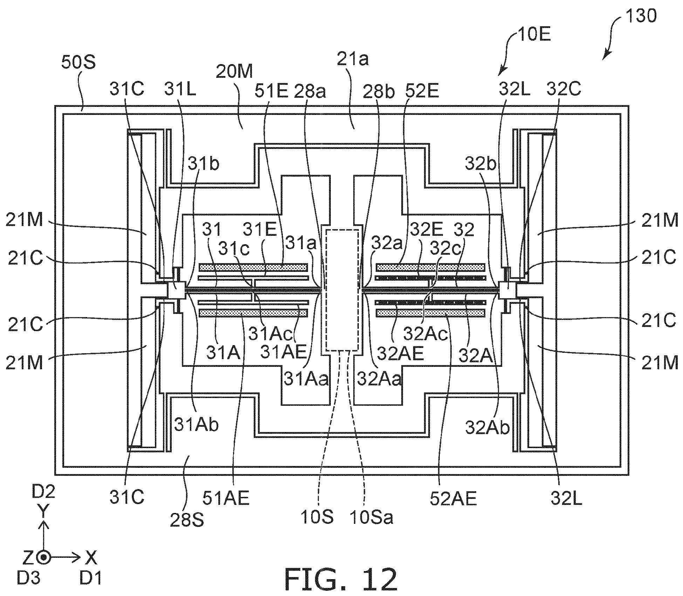

FIG. 12 is a schematic plan view illustrating a sensor in accordance with an example useful for understanding the invention.

As shown in FIG. 12, in a sensor 130, the element section 10E includes the first beam 31, the first opposing beam 31A, the first linking portion 31L, a first connecting portion 31C, a second beam 32, a second opposing beam 32A, the second linking portion 32L, the second connecting portion 32C. In sensor 130, the configuration of first beam 31 and second beam 32 is different from that in the sensor 120. Except for this, the configuration of the sensor 130 may be the same as the configuration of the sensor 120.

In the sensor 130, the first support region 28a is provided between the first linking portion 31L and the second linking portion 32L in the first direction D1. The second support region 28b is provided between the first support region 28a and the second linking portion 32L in the first direction D1. The sensor 130 also provides a highly linear scale-factor, a large scale-factor, and high operational stability. A high Q value is obtained. A sensor capable of improving characteristics can be provided.

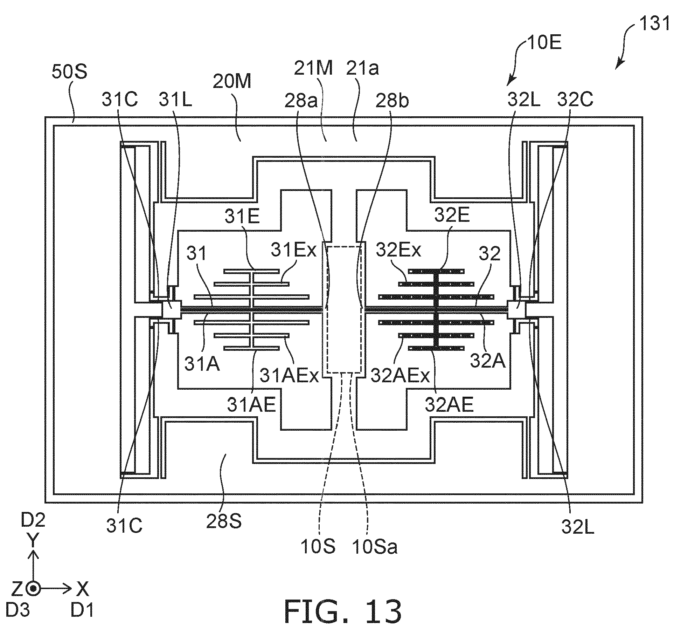

FIG. 13 is a schematic plan view illustrating a sensor in accordance with an example useful for understanding the invention.

As shown in FIG. 13, in a sensor 131, the plurality of first extending portions 31Ex, the plurality of first opposing extending portions 31AEx, the plurality of second extending portions 32Ex, and the plurality of second opposing extending portion 32AEx are provided. Except for this, the configuration of the sensor 131 may be the same as the configuration of the sensor 130.

The plurality of first extending portions 31Ex, the plurality of first opposing extending portions 31AEx, the plurality of second extending portions 32Ex, and the plurality of second opposing extending portions 32AEx may have, for example, the configuration described with respect to the sensor 111.

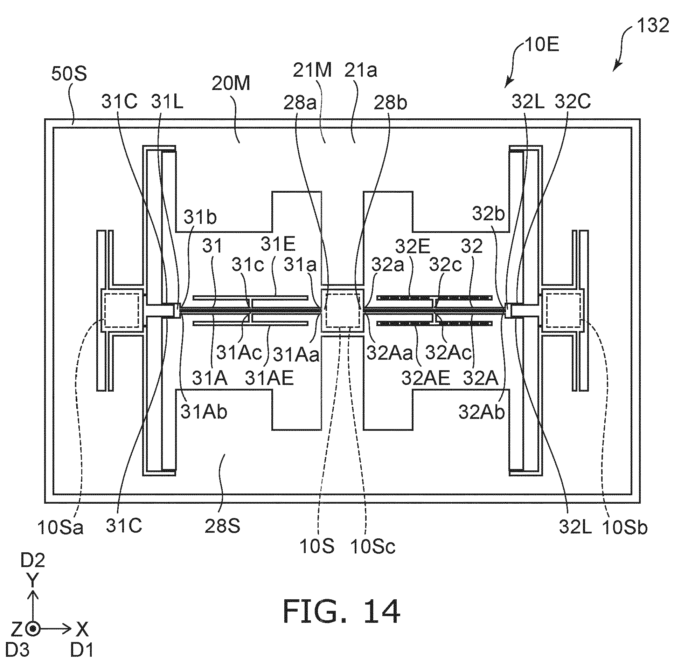

FIG. 14 is a schematic plan view illustrating a sensor in accordance with an example useful for understanding the invention.

As shown in FIG. 14, in a sensor 132, the first fixed portion 10S includes the first fixed region 10Sa, the second fixed region 10Sb, and the third fixed region 10Sc. Except for this, the configuration of the sensor 132 may be the same as the configuration of the sensor 130. In the sensor 132, the first support region 28a is supported by the first fixed region 10Sa. The second support region 28b is supported by the second fixed region 10Sb. The third support region 28c is supported by the third fixed region 10Sc.

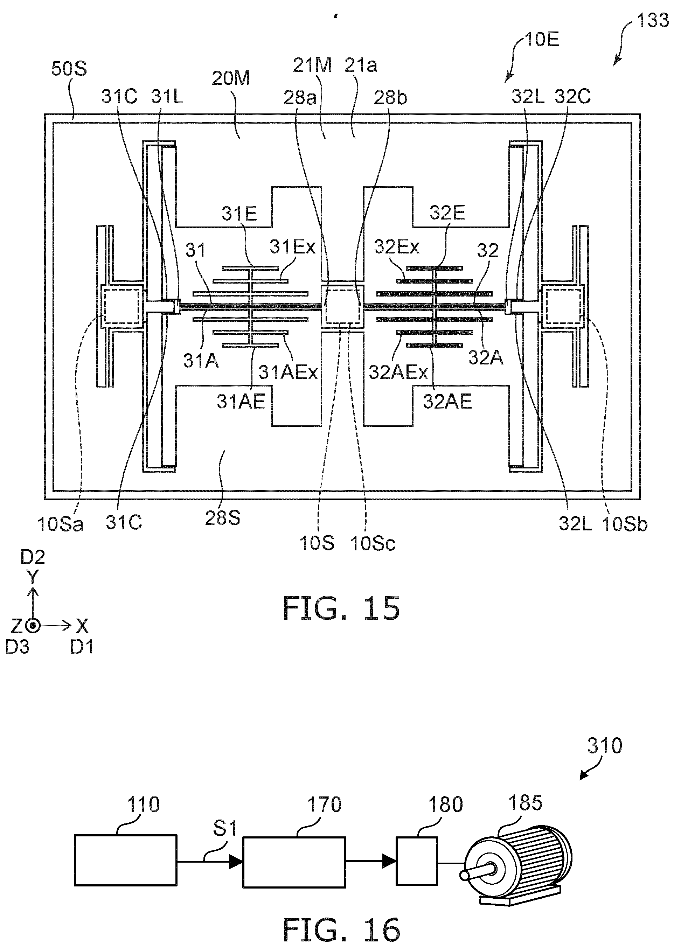

FIG. 15 is a schematic plan view illustrating a sensor in accordance with an example useful for understanding the invention.

As shown in FIG. 15, in a sensor 133 according to the embodiment, the first fixed portion 10S includes the first fixed region 10Sa, the second fixed region 10Sb, and the third fixed region 10Sc. Except for this, the configuration of the sensor 133 may be the same as the configuration of the sensor 131.

### Second Embodiment

The second embodiment relates to an electronic device.

FIG. 16 is a schematic diagram illustrating an electronic device.

As shown in FIG. 16, an electronic device 310 according to the embodiment includes the sensor according to the first embodiment and a circuit controller 170. In the example of FIG. 16, the sensor 110 is drawn as the sensor. In accordance with an embodiment, the sensor is the sensor of any of FIGs. 8-11 above. The circuit controller 170 is configured to control a circuit 180 based on a signal S1 obtained from the sensor. The circuit 180 is, for example, a control circuit of a driving device 185 or the like. According to the embodiment, for example, the circuit 180 for controlling the driving device 185 can be controlled with high accuracy.

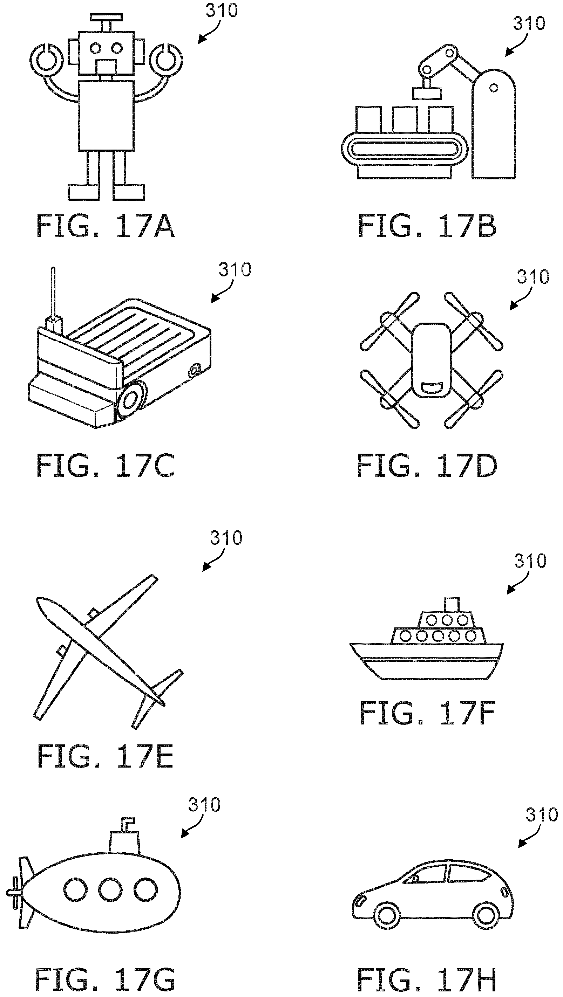

FIGS. 17A to 17H are schematic diagrams illustrating applications of the electronic device according to the embodiment.

As shown in FIG. 17A, the electronic device 310 may be at least a part of a robot. As shown in FIG. 17B, the electronic device 310 may be at least a part of a work robot provided in a manufacturing factory or the like. As shown in FIG. 17C, the electronic device 310 may be at least a part of an automated guided vehicle such as in a factory. As shown in FIG. 17D, the electronic device 310 may be at least a part of a drone (unmanned aerial vehicle). As shown in FIG. 17E, the electronic device 310 may be at least a part of an airplane. As shown in FIG. 17F, the electronic device 310 may be at least a part of a vessel. As shown in FIG. 17G, the electronic device 310 may be at least a part of a submarine. As shown in FIG. 17H, the electronic device 310 may be at least a part of an automobile. The electronic device 310 may include, for example, at least one of a robot or a mobile object.

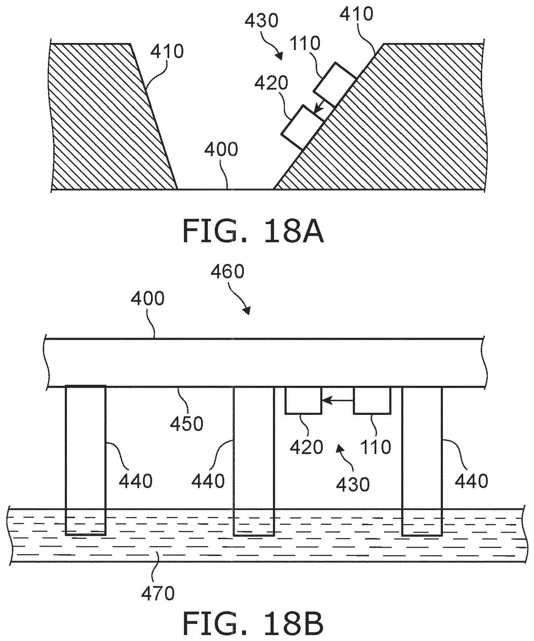

FIGS. 18A and 18B are schematic diagrams illustrating applications of the sensor according to the embodiment.

As shown in FIG. 18A, a sensor 430 according to the embodiment includes the sensor according to the first embodiment and a transmitter/receiver 420. In the example of FIG. 18A, the sensor 110 is drawn as the sensor. The transmitter/receiver 420 is configured to transmit the signal obtained from the sensor 110 by at least one of wireless or wired methods, for example. The sensor 430 is provided, for example, on a slope surface 410 such as a road 400. The sensor 430 may, for example, monitor conditions such as facilities (e.g., infrastructure). The sensor 430 may be, for example, a condition monitoring device.

For example, the sensor 430 detects changes in the state of the slope surface 410 of the road 400 with high accuracy. A change in the state of the slope surface 410 includes, for example, at least one of a change in tilt angle or a change in vibration state. The signal (test result) obtained from the sensor 110 is transmitted by the transmitter/receiver 420. The condition of facilities (e.g., infrastructure) can be monitored, e.g., continuously.

As shown in FIG. 18B, the sensor 430 is provided on a part of a bridge 460, for example. The bridge 460 is provided over a river 470. For example, the bridge 460 includes at least one of main girder 450 and a bridge pier 440. The sensor 430 is provided on at least one of the main girder 450 and the bridge pier 440. For example, the angle of at least one of the main girder 450 and the bridge pier 440 may change due to deterioration or the like. For example, in at least one of the main girder 450 and the bridge pier 440, the vibration state may change. The sensor 430 detects these changes with high accuracy. A detection result can be transmitted to an arbitrary place by the transmitter/receiver 420. Anomalies can be effectively detected.

According to the embodiments, a sensor and an electronic devices capable of enhanced properties can be provided.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in sensors such as bases, element sections, support portions, controllers, etc., from known art. Such practice is included in the scope of the invention to the extent that similar effects thereto are obtained.

Further, any two or more components of the specific examples may be combined within the extent of technical feasibility and are included in the invention as long as they fall within the scope of the invention as defined by the claims.

Moreover, all sensors and electronic devices practicable by an appropriate design modification by one skilled in the art based on the sensors and the electronic devices described above as embodiments of the invention also are within the invention as long as they fall within the scope of the invention as defined by the claims.

While certain embodiments have been described, these embodiments have been presented by way of example only, and are not intended to limit the scope of the invention. Indeed, the embodiments described herein may be embodied in a variety of other forms; furthermore, various omissions, substitutions and changes in the form of the embodiments described herein may be made without departing from the invention as long as they fall within the scope of the invention as defined by the claims.

## Claims

1. A sensor (120-123), comprising:
an element section (10E);
a base (50S); and
a first fixed portion (10S) fixed to the base,
the element section (10E) including:
a first beam (31) including a first portion (31a) and a first other portion (31b), a direction from the first portion to the first other portion being along a first direction (D1);
a first opposing beam (31A), a second direction (D2) from the first opposing beam to the first beam crossing the first direction, the first opposing beam including a first opposing portion (31Aa) and a first other opposing portion (31Ab), a direction from the first opposing portion (31Aa) to the first other opposing portion (31Ab) being along the first direction;
a support portion (28S) including a first support region (28a) connected to the first portion and the first opposing portion;
a first linking portion (31L) connected to the first other portion (31b) and the first other opposing portion (31Ab); and
a first connecting portion (31C) connected to the first linking portion (31L), the first linking portion (31L) being provided between the first beam (31) and the first connecting portion (31C) and between the first opposing beam (31A) and the first connecting portion (31C), a first connecting portion width (w31C) along the second direction of the first connecting portion being narrower than a first linking portion width (w31L) along the second direction of the first linking portion,
a third direction (D3) from the base to the first fixed portion crossing a plane including the first direction and the second direction,
the first support region (28a) being supported by the first fixed portion,
a first gap (g1) being provided between the base and the element section,
wherein
the support portion (28S) further includes a second support region (28b), and a third support region (28c),
the element section (10E) includes a movable member (20M) supported by the third support region (28c),
the movable member (20M) including a first movable base portion (21B), a first movable connecting portion (21C), a first movable portion (21a), and a first movable intermediate portion (21M),
the first movable connecting portion (21C) is between the first movable base portion (21B) and the first movable intermediate portion (21M) in the second direction,
the first movable portion (21a) is between the first movable connecting portion (21C) and the first movable intermediate portion (21M) in the second direction (D2),
the first connecting portion (31C) is connected to the first movable portion (21a),
the first beam (31) further includes a first intermediate portion (31c) provided between the first portion (31a) and the first other portion (31b),
the first opposing beam (31A) further includes a first opposing intermediate portion (31Ac) provided between the first opposing portion (31Aa) and the first other opposing portion (31Ab),
the element section (10E) includes
a first beam electrode (31E) connected to the first intermediate portion (31c), and
a first opposing beam electrode (31AE) connected to the first opposing intermediate portion (31Ac),
the first beam (31) is provided between the first opposing beam electrode (31AE) and the first beam electrode (31E), and
the first opposing beam (31A) is provided between the first opposing beam electrode (31AE) and the first beam (31),
the element section (10E) includes a second beam (32), a second opposing beam (32A), a second linking portion (32L), and a second connecting portion (32C),
the first movable portion (21a) is between the first connecting portion (31C) and the second connecting portion (32C) in the first direction (D1),
the first linking portion (31L) is between the first support region (28a) and the first movable portion (21a) in the first direction,
the second linking portion (32L) is between the first movable portion (21a) and the second support region (28b) in the first direction,
the second beam (32) includes a second portion (32a) and a second other portion (32b), a direction from the second portion (32a) to the second other portion (32b) is along the first direction,
a direction from the first beam (31) to the second beam (32) is along the first direction (D1),
the second opposing beam (32A) includes a second opposing portion (32Aa) and a second other opposing portion(32Ab), a direction from the second opposing portion (32Aa) to the second other opposing portion (32Ab) is along the first direction,
a direction from the first opposing beam (31A) to the second opposing beam (32A) is along the first direction,
the second support region (28b) is connected to the second portion (32a) and the second opposing portion (32Aa),
the second linking portion (32L) is connected to the second other portion (32b) and the second other opposing portion (32Ab),
the second connecting portion (32C) is connected to the first movable portion (21a),
the second connecting portion (32C) is connected to the second linking portion (32L),
the second linking portion (32L) is provided between the second beam (32) and the second connecting portion (32C) and between the second opposing beam (32A) and the second connecting portion (32C), and
a second connecting portion width (w32C) along the second direction of the second connecting portion (32C) is narrower than a second linking portion width (w32L) along the second direction of the second linking portion (32L).

2. The sensor according to claim 1, wherein
the second beam (32) further includes a second intermediate portion (32c) provided between the second portion (32a) and the second other portion (32b),
the second opposing beam (32A) further includes a second opposing intermediate portion (32Ac) provided between the second opposing portion (32Aa) and the second other opposing portion (32Ab),
the element section (10E) includes
a second beam electrode (32E) connected to the second intermediate portion (32c), and
a second opposing beam electrode (32AE) connected to the second opposing intermediate portion (32Ac),
the second beam (32) is provided between the second opposing beam electrode (32AE) and the second beam electrode (32A), and
the second opposing beam (32A) is provided between the second opposing beam electrode (32AE) and the second beam (32).

3. The sensor according to claim 2, wherein
the second beam electrode (32E) includes
a second extending portion (32Ex) extending along the first direction (D1), and
a second extending connecting portion (32Ec) connecting the second extending portion (32Ex) to the second intermediate portion (32c), the second extending connecting portion (32Ec) extending along the second direction (D2),
the second opposing beam electrode (32AE) includes
a second opposing extending portion (32AEx) extending along the first direction (D1), and
a second opposing extending connecting portion (32AEc) connecting the second opposing extending portion (32AEx) to the second opposing intermediate portion (32Ac), the second opposing extending connecting portion (32AEx) extending along the second direction (D2).

4. The sensor according to claim 3, wherein
the second beam electrode (32E) includes a plurality of the second extending portions (32Ex),
the second opposing beam electrode (32AE) includes a plurality of the second opposing extending portions (32AEx),
one of the plurality of second extending portions (32Ex) is provided between the second beam (32) and another one of the plurality of second extending portions (32Ex),
a length of the one of the plurality of second extending portions (32Ex) along the first direction is longer than a length of the other one of the plurality of second extending portions (32Ex) along the first direction (D1),
one of the plurality of second opposing extending portions (32AEx) is provided between the second opposing beam (32A) and another one of the plurality of second opposing extending portions (32AEx), and
a length of the one of the plurality of second opposing extending portions (32AEx) along the first direction (D1) is longer than a length of the other one of the plurality of second opposing extending portions (32AEx) along the first direction (D1).

5. The sensor according to any one of claims 2-4, wherein
the first beam electrode (31E) and the second beam electrode (32E) satisfy at least one of the first condition, the second condition, the third condition, the fourth condition, the fifth condition, the sixth condition, the seventh condition or the eighth condition,
in the first condition, a second mass of the second beam electrode (32E) is different from a first mass of the first beam electrode (31E),
in the second condition, a second thickness of the second beam electrode (32E) along the third direction (D3) is different from a first thickness of the first beam electrode (31E) along the third direction (D3),
in the third condition, at least a part of a second material included in the second beam electrode (32E) is different from at least a part of a first material included in the first beam electrode (31E),
in the fourth condition, a second size of a second hole included in the second beam electrode (32E) is different from a first size of a first hole included in the first beam electrode (31E),
in the fifth condition, a second density of the second holes is different from a first density of the first holes,
in the sixth condition, a second number of the second holes is different from a first number of the first holes,
in the seventh condition, a second shape of the second hole is different from a first shape of the first hole, and
in the eighth condition, a second layer structure of the second beam electrode (32E) is different from a first layer structure of the first beam electrode (31E).

6. The sensor according to claim 1, wherein
the element section (10E) further includes a first fixed electrode (51E) and a first opposing fixed electrode (51AE) fixed to the base,
the first fixed electrode (51E) faces the first beam electrode (31E),
the first opposing fixed electrode (51AE) faces the first opposing beam electrode (31AE),
a direction from the first fixed electrode (51E) to the first beam electrode (31E) is along the second direction (D2), and
a direction from the first opposing fixed electrode (51AE) to the first opposing beam electrode (31A) is along the second direction (D2).

7. The sensor according to claim 6, further comprising:
a controller (70),
the controller being configured to apply a first AC signal between the first fixed electrode (51E) and the first beam electrode (31E), and
the controller (70) being configured to detect a first signal generated between the first opposing fixed electrode (51AE) and the first opposing beam electrode (31AE).

8. An electronic device, comprising:
the sensor according to any one of claims 1-7; and
a circuit controller (170) configured to control a circuit (180) based on a signal obtained from the sensor.

## Patentansprüche

1. Sensor (120-123), umfassend:
einen Elementabschnitt (10E);
eine Basis (50S); und
einen ersten festen Abschnitt (10S), der an der Basis befestigt ist,
wobei der Elementabschnitt (10E) Folgendes beinhaltet:
einen ersten Balken (31), der einen ersten Abschnitt (31a) und einen ersten anderen Abschnitt (31b) beinhaltet, wobei eine Richtung vom ersten Abschnitt zum ersten anderen Abschnitt entlang einer ersten Richtung (D1) verläuft;
einen ersten gegenüberliegenden Balken (31A), wobei eine zweite Richtung (D2) vom ersten gegenüberliegenden Balken zum ersten Balken die erste Richtung kreuzt, wobei der erste gegenüberliegende Balken einen ersten gegenüberliegenden Abschnitt (31Aa) und einen ersten anderen gegenüberliegenden Abschnitt (31Ab) beinhaltet, wobei eine Richtung vom ersten gegenüberliegenden Abschnitt (31Aa) zum ersten anderen gegenüberliegenden Abschnitt (31Ab) entlang der ersten Richtung verläuft;
einen Halteabschnitt (28S), der einen ersten Haltebereich (28a) beinhaltet, der mit dem ersten Abschnitt und dem ersten gegenüberliegenden Abschnitt verbunden ist;
einen ersten Verknüpfungsabschnitt (31L), der mit dem ersten anderen Abschnitt (31b) und dem ersten anderen gegenüberliegenden Abschnitt (31Ab) verbunden ist; und
einen ersten Verbindungsabschnitt (31C), der mit dem ersten Verknüpfungsabschnitt (31L) verbunden ist, wobei der erste Verknüpfungsabschnitt (31L) zwischen dem ersten Balken (31) und dem ersten Verbindungsabschnitt (31C) sowie zwischen dem ersten gegenüberliegenden Balken (31A) und dem ersten Verbindungsabschnitt (31C) vorgesehen ist, wobei die Breite (w31C) des ersten Verbindungsabschnitts entlang der zweiten Richtung des ersten Verbindungsabschnitts geringer ist als die Breite (w31L) des ersten Verknüpfungsabschnitts entlang der zweiten Richtung des ersten Verknüpfungsabschnitts,
wobei eine dritte Richtung (D3) von der Basis zum ersten festen Abschnitt eine Ebene kreuzt, welche die erste Richtung und die zweite Richtung beinhaltet,
wobei der erste Haltebereich (28a) vom ersten festen Abschnitt gehalten wird,
wobei zwischen der Basis und dem Elementabschnitt ein erster Spalt (g1) vorgesehen ist,
wobei
der Halteabschnitt (28S) außerdem einen zweiten Haltebereich (28b) und einen dritten Haltebereich (28c) beinhaltet,
der Elementabschnitt (10E) ein bewegliches Element (20M) beinhaltet, das von dem dritten Haltebereich (28c) gehalten wird,
das bewegliche Element (20M) einen ersten beweglichen Basisabschnitt (21B), einen ersten beweglichen Verbindungsabschnitt (21C), einen ersten beweglichen Abschnitt (21a) und einen ersten beweglichen Zwischenabschnitt (21M) beinhaltet,
sich der erste bewegliche Verbindungsabschnitt (21C) in der zweiten Richtung zwischen dem ersten beweglichen Basisabschnitt (21B) und dem ersten beweglichen Zwischenabschnitt (21M) befindet,
sich der erste bewegliche Abschnitt (21a) in der zweiten Richtung (D2) zwischen dem ersten beweglichen Verbindungsabschnitt (21C) und dem ersten beweglichen Zwischenabschnitt (21M) befindet,
der erste Verbindungsabschnitt (31C) mit dem ersten beweglichen Abschnitt (21a) verbunden ist,
der erste Balken (31) ferner einen ersten Zwischenabschnitt (31c) beinhaltet, der zwischen dem ersten Abschnitt (31a) und dem ersten anderen Abschnitt (31b) vorgesehen ist,
der erste gegenüberliegende Balken (31A) ferner einen ersten gegenüberliegenden Zwischenabschnitt (31Ac) beinhaltet, der zwischen dem ersten gegenüberliegenden Abschnitt (31Aa) und dem ersten anderen gegenüberliegenden Abschnitt (31Ab) vorgesehen ist,
der Elementabschnitt (10E) Folgendes beinhaltet:
eine erste Balkenelektrode (31E), die mit dem ersten Zwischenabschnitt (31c) verbunden ist, und
eine erste gegenüberliegende Balkenelektrode (31AE), die mit dem ersten gegenüberliegenden Zwischenabschnitt (31Ac) verbunden ist,
der erste Balken (31) zwischen der ersten gegenüberliegenden Balkenelektrode (31AE) und der ersten Balkenelektrode (31E) vorgesehen ist, und
der erste gegenüberliegende Balken (31A) zwischen der ersten gegenüberliegenden Balkenelektrode (31AE) und dem ersten Balken (31) vorgesehen ist,
der Elementabschnitt (10E) einen zweiten Balken (32), einen zweiten gegenüberliegenden Balken (32A), einen zweiten Verknüpfungsabschnitt (32L) und einen zweiten Verbindungsabschnitt (32C) beinhaltet,
sich der erste bewegliche Abschnitt (21a) in der ersten Richtung (D1) zwischen dem ersten Verbindungsabschnitt (31C) und dem zweiten Verbindungsabschnitt (32C) befindet,
sich der erste Verknüpfungsabschnitt (31L) in der ersten Richtung zwischen dem ersten Haltebereich (28a) und dem ersten beweglichen Abschnitt (21a) befindet,
sich der zweite Verknüpfungsabschnitt (32L) in der ersten Richtung zwischen dem ersten beweglichen Abschnitt (21a) und dem zweiten Haltebereich (28b) befindet,
der zweite Balken (32) einen zweiten Abschnitt (32a) und einen zweiten anderen Abschnitt (32b) beinhaltet, wobei eine Richtung vom zweiten Abschnitt (32a) zum zweiten anderen Abschnitt (32b) entlang der ersten Richtung verläuft,
eine Richtung vom ersten Balken (31) zum zweiten Balken (32) entlang der ersten Richtung (D1) verläuft,
der zweite gegenüberliegende Balken (32A) einen zweiten gegenüberliegenden Abschnitt (32Aa) und einen zweiten anderen gegenüberliegenden Abschnitt (32Ab) beinhaltet, wobei eine Richtung vom zweiten gegenüberliegenden Abschnitt (32Aa) zum zweiten anderen gegenüberliegenden Abschnitt (32Ab) entlang der ersten Richtung verläuft,
die Richtung vom ersten gegenüberliegenden Balken (31A) zum zweiten gegenüberliegenden Balken (32A) entlang der ersten Richtung verläuft,
der zweite Haltebereich (28b) mit dem zweiten Abschnitt (32a) und dem zweiten gegenüberliegenden Abschnitt (32Aa) verbunden ist,
der zweite Verknüpfungsabschnitt (32L) mit dem zweiten anderen Abschnitt (32b) und dem zweiten anderen gegenüberliegenden Abschnitt (32Ab) verbunden ist,
der zweite Verbindungsabschnitt (32C) mit dem ersten beweglichen Abschnitt (21a) verbunden ist,
der zweite Verbindungsabschnitt (32C) mit dem zweiten Verknüpfungsabschnitt (32L) verbunden ist,
der zweite Verknüpfungsabschnitt (32L) zwischen dem zweiten Balken (32) und dem zweiten Verbindungsabschnitt (32C) sowie zwischen dem zweiten gegenüberliegenden Balken (32A) und dem zweiten Verbindungsabschnitt (32C) vorgesehen ist,
eine Breite des zweiten Verbindungsabschnitts (w32C) entlang der zweiten Richtung des zweiten Verbindungsabschnitts (32C) geringer ist als eine Breite des zweiten Verknüpfungsabschnitts (w32L) entlang der zweiten Richtung des zweiten Verknüpfungsabschnitts (32L).

2. Sensor nach Anspruch 1, wobei
der zweite Balken (32) ferner einen zweiten Zwischenabsschnitt (32c) beinhaltet, der zwischen dem zweiten Abschnitt (32a) und dem zweiten anderen Abschnitt (32b) vorgesehen ist,
der zweite gegenüberliegende Balken (32A) ferner einen zweiten gegenüberliegenden Zwischenabschnitt (32Ac) beinhaltet, der zwischen dem zweiten gegenüberliegenden Abschnitt (32Aa) und dem zweiten anderen gegenüberliegenden Abschnitt (32Ab) vorgesehen ist,
der Elementabschnitt (10E) Folgendes beinhaltet:
eine zweite Balkenelektrode (32E), die mit dem zweiten Zwischenabschnitt (32c) verbunden ist, und
eine zweite gegenüberliegende Balkenelektrode (32AE), die mit dem zweiten gegenüberliegenden Zwischenabschnitt (32Ac) verbunden ist,
der zweite Balken (32) zwischen der zweiten gegenüberliegenden Balkenelektrode (32AE) und der zweiten Balkenelektrode (32A) vorgesehen ist, und
der zweite gegenüberliegende Balken (32A) zwischen der zweiten gegenüberliegenden Balkenelektrode (32AE) und dem zweiten Balken (32) vorgesehen ist.

3. Sensor nach Anspruch 2, wobei
die zweite Balkenelektrode (32E) Folgendes beinhaltet:
einen zweiten Erstreckungsabschnitt (32Ex), der sich entlang der ersten Richtung (D1) erstreckt, und
einen zweiten Erstreckungs- und Verbindungsabschnitt (32Ec), der den zweiten Erstreckungsabschnitt (32Ex) mit dem zweiten Zwischenabschnitt (32c) verbindet, wobei sich der zweite Erstreckungs- und Verbindungsabschnitt (32Ec) entlang der zweiten Richtung (D2) erstreckt,
die zweite gegenüberliegende Balkenelektrode (32AE) Folgendes beinhaltet:
einen zweiten gegenüberliegenden Erstreckungs- und Verbindungsabschnitt (32AEx), der sich entlang der ersten Richtung (D1) erstreckt, und
einen zweiten gegenüberliegenden Erstreckungs- und Verbindungsabschnitt (32AEc), der den zweiten gegenüberliegenden Erstreckungsabschnitt (32AEx) mit dem zweiten gegenüberliegenden Zwischenabschnitt (32Ac) verbindet, wobei sich der zweite gegenüberliegende Erstreckungs- und Verbindungsabschnitt (32AEx) entlang der zweiten Richtung (D2) erstreckt.

4. Sensor nach Anspruch 3, wobei
die zweite Balkenelektrode (32E) eine Vielzahl der zweiten Erstreckungsabschnitte (32Ex) beinhaltet,
die zweite gegenüberliegende Balkenelektrode (32AE) eine Vielzahl der zweiten gegenüberliegenden Erstreckungsabschnitte (32AEx) beinhaltet,
einer von der Vielzahl von zweiten Erstreckungsabschnitten (32Ex) zwischen dem zweiten Balken (32) und einem anderen von der Vielzahl von zweiten Erstreckungsabschnitten (32Ex) vorgesehen ist,
eine Länge von dem einen von der Vielzahl von zweiten Erstreckungsabschnitten (32Ex) entlang der ersten Richtung länger ist als eine Länge des anderen von der Vielzahl von zweiten Erstreckungsabschnitten (32Ex) entlang der ersten Richtung (D1),
einer von der Vielzahl von zweiten gegenüberliegenden Erstreckungsabschnitten (32AEx) zwischen dem zweiten gegenüberliegenden Balken (32A) und einem anderen von der Vielzahl von zweiten gegenüberliegenden Erstreckungsabschnitten (32AEx) vorgesehen ist, und
eine Länge von dem einen von der Vielzahl von zweiten gegenüberliegenden Erstreckungsabschnitten (32AEx) entlang der ersten Richtung (D1) länger ist als eine Länge des anderen von der Vielzahl von zweiten gegenüberliegenden Erstreckungsabschnitten (32AEx) entlang der ersten Richtung (D1).

5. Sensor nach einem der Ansprüche 2-4,
wobei die erste Balkenelektrode (31E) und die zweite Balkenelektrode (32E) von der ersten Bedingung, zweiten Bedingung, dritten Bedingung, vierten Bedingung, fünften Bedingung, sechsten Bedingung, siebten Bedingung oder achten Bedingung mindestens eine erfüllen,
sich bei der ersten Bedingung eine zweite Masse der zweiten Balkenelektrode (32E) von einer ersten Masse der ersten Balkenelektrode (31E) unterscheidet,
sich bei der zweiten Bedingung eine zweite Dicke der zweiten Balkenelektrode (32E) entlang der dritten Richtung (D3) von einer ersten Dicke der ersten Balkenelektrode (31E) entlang der dritten Richtung (D3) unterscheidet,
sich bei der dritten Bedingung mindestens ein Teil eines zweiten Materials, das in der zweiten Balkenelektrode (32E) eingeschlossen ist, von mindestens einem Teil eines ersten Materials unterscheidet, das in der ersten Balkenelektrode (31E) eingeschlossen ist,
sich bei der vierten Bedingung eine zweite Größe eines zweiten Lochs, das in der zweiten Balkenelektrode (32E) eingeschlossen ist, von einer ersten Größe eines ersten Lochs unterscheidet, das in der ersten Balkenelektrode (31E) eingeschlossen ist,
sich bei der fünften Bedingung eine zweite Dichte der zweiten Löcher von einer ersten Dichte der ersten Löcher unterscheidet,
sich bei der sechsten Bedingung eine zweite Anzahl der zweiten Löcher von einer ersten Anzahl der ersten Löcher unterscheidet,
sich bei der siebten Bedingung eine zweite Form des zweiten Lochs von einer ersten Form des ersten Lochs unterscheidet, und
sich bei der achten Bedingung die zweite Schichtstruktur der zweiten Balkenelektrode (32E) von der ersten Schichtstruktur der ersten Balkenelektrode (31E) unterscheidet.

6. Sensor nach Anspruch 1, wobei
der Elementabschnitt (10E) ferner eine erste feste Elektrode (51E) und eine erste gegenüberliegende feste Elektrode (51AE) beinhaltet, die an der Basis befestigt sind,
die erste feste Elektrode (51E) der ersten Balkenelektrode (31E) zugewandt ist,
die erste gegenüberliegende feste Elektrode (51AE) der ersten gegenüberliegenden Balkenelektrode (31AE) zugewandt ist,
eine Richtung von der ersten festen Elektrode (51E) zur ersten Balkenelektrode (31E) entlang der zweiten Richtung (D2) verläuft, und
eine Richtung von der ersten gegenüberliegenden festen Elektrode (51AE) zur ersten gegenüberliegenden Balkenelektrode (31A) entlang der zweiten Richtung (D2) verläuft.

7. Sensor nach Anspruch 6, ferner umfassend:
eine Steuereinheit (70),
wobei die Steuereinheit so konfiguriert ist, dass sie ein erstes Wechselstromsignal zwischen der ersten festen Elektrode (51E) und der ersten Balkenelektrode (31E) anlegt, und
wobei die Steuereinheit (70) so konfiguriert ist, dass sie ein erstes Signal erfasst, das zwischen der ersten gegenüberliegenden festen Elektrode (51AE) und der ersten gegenüberliegenden Balkenelektrode (31AE) erzeugt wird.

8. Elektronische Vorrichtung, umfassend:
den Sensor nach einem der Ansprüche 1-7; und
eine Schaltungssteuereinheit (170), die so konfiguriert ist, dass sie auf der Grundlage eines vom Sensor erhaltenen Signals eine Schaltung (180) steuert.

## Revendications

1. Capteur (120-123), comprenant :
une section d'éléments (10E) ;
une base (505) ; et
une première portion fixe (10S) fixée à la base,
la section d'éléments (10E) incluant :
une première poutre (31) incluant une première portion (31a) et une première autre portion (31b), une direction de la première portion à la première autre portion étant le long d'une première direction (D1) ;
une première poutre opposée (31A), une deuxième direction (D2) de la première poutre opposée à la première poutre croisant la première direction, la première poutre opposée incluant une première portion opposée (31Aa) et une première autre portion opposée (31Ab), une direction de la première portion opposée (31Aa) à la première autre portion opposée (31Ab) étant le long de la première direction ;
une portion de support (285) incluant une première région de support (28a) connectée à la première portion et à la première portion opposée ;
une première portion de liaison (31L) connectée à la première autre portion (31b) et à la première autre portion opposée (31Ab) ; et
une première portion de connexion (31C) connectée à la première portion de liaison (31L), la première portion de liaison (31L) étant prévue entre la première poutre (31) et la première portion de connexion (31C) et entre la première poutre opposée (31A) et la première portion de connexion (31C), une première largeur de portion de connexion (w31C) dans la seconde direction de la première portion de connexion étant plus étroite qu'une première largeur de portion de liaison (w31L) dans la deuxième direction de la première portion de liaison,
une troisième direction (D3) de la base à la première portion fixe croisant un plan incluant la première direction et la deuxième direction,
la première région de support (28a) étant supportée par la première portion fixe,
un premier espace (g1) étant prévu entre la base et la section d'éléments,
dans lequel
la portion de support (28S) inclut en outre une deuxième région de support (28b) et une troisième région de support (28c),
la section d'éléments (10E) inclut un élément mobile (20M) supporté par la troisième région de support (28c),
l'élément mobile (20M) incluant une première portion de base mobile (21B), une première portion de connexion mobile (21C), une première portion mobile (21a) et une première portion intermédiaire mobile (21M),
la première portion de connexion mobile (21C) se trouve entre la première portion de base mobile (21B) et la première portion intermédiaire mobile (21M) dans la deuxième direction,
la première portion mobile (21a) se trouve entre la première portion de connexion mobile (21C) et la première portion intermédiaire mobile (21M) dans la deuxième direction (D2),
la première portion de connexion (31C) est connectée à la première portion mobile (21a),
la première poutre (31) inclut en outre une première portion intermédiaire (31c) prévue entre la première portion (31a) et la première autre portion (31b),
la première poutre opposée (31A) inclut en outre une première portion intermédiaire opposée (31Ac) prévue entre la première portion opposée (31Aa) et la première autre portion opposée (31Ab),
la section d'éléments (10E) inclut
une électrode de première poutre (31E) connectée à la première portion intermédiaire (31c), et
une électrode de première poutre opposée (31AE) connectée à la première portion intermédiaire opposée (31Ac),
la première poutre (31) est prévue entre l'électrode de première poutre opposée (31AE) et l'électrode de première poutre (31E), et
la première poutre opposée (31A) est prévue entre l'électrode de première poutre opposée (31AE) et la première poutre (31),
la section d'éléments (10E) inclut une seconde poutre (32), une seconde poutre opposée (32A), une seconde portion de liaison (32L) et une seconde portion de connexion (32C),
la première portion mobile (21a) se trouve entre la première portion de connexion (31C) et la seconde portion de connexion (32C) dans la première direction (D1),
la première portion de liaison (31L) se trouve entre la première région de support (28a) et la première portion mobile (21a) dans la première direction,
la seconde portion de liaison (32L) se trouve entre la première portion mobile (21a) et la deuxième région de support (28b) dans la première direction,
la seconde poutre (32) inclut une seconde portion (32a) et une seconde autre portion (32b), une direction de la seconde portion (32a) à la seconde autre portion (32b) est le long de la première direction,
une direction de la première poutre (31) à la seconde poutre (32) est le long de la première direction (D1),
la seconde poutre opposée (32A) inclut une seconde portion opposée (32Aa) et une seconde autre portion opposée (32Ab), une direction de la seconde portion opposée (32Aa) à la seconde autre portion opposée (32Ab) est le long de la première direction,
une direction allant de la première poutre opposée (31A) à la seconde poutre opposée (32A) est le long de la première direction,
la deuxième région de support (28b) est connectée à la seconde portion (32a) et à la seconde portion opposée (32Aa),
la seconde portion de liaison (32L) est connectée à la seconde autre portion (32b) et à la seconde autre portion opposée (32Ab),
la seconde portion de connexion (32C) est connectée à la première portion mobile (21a),
la seconde portion de connexion (32C) est connectée à la seconde portion de liaison (32L),
la seconde portion de liaison (32L) est prévue entre la seconde poutre (32) et la seconde portion de connexion (32C) et entre la seconde poutre opposée (32A) et la seconde portion de connexion (32C), et
une seconde largeur de portion de connexion (w32C) le long de la deuxième direction de la seconde portion de connexion (32C) est plus étroite qu'une seconde largeur de portion de liaison (w32L) le long de la deuxième direction de la seconde portion de liaison (32L).

2. Capteur selon la revendication 1, dans lequel
la seconde poutre (32) inclut en outre une seconde portion intermédiaire (32c) prévue entre la seconde portion (32a) et la seconde autre portion (32b),
la seconde poutre opposé (32A) inclut en outre une seconde portion intermédiaire opposée (32Ac) prévue entre la seconde portion opposée (32Aa) et la seconde autre portion opposée (32Ab),
la section d'éléments (10E) inclut
une électrode de seconde poutre (32E) connectée à la seconde portion intermédiaire (32c), et
une électrode de seconde poutre opposée (32AE) connectée à la seconde portion intermédiaire opposée (32Ac), et
la seconde poutre (32) est prévue entre l'électrode de seconde poutre opposée (32AE) et l'électrode de seconde poutre (32A), et
la seconde poutre opposée (32A) est prévue entre l'électrode de seconde poutre opposée (32AE) et la seconde poutre (32).

3. Capteur selon la revendication 2, dans lequel
l'électrode de seconde poutre (32E) inclut
une seconde portion d'extension (32Ex) s'étendant le long de la première direction (D1), et
une seconde portion de connexion d'extension (32Ec) connectant la seconde portion d'extension (32Ex) à la seconde portion intermédiaire (32c), la seconde portion de connexion d'extension (32Ec) s'étendant le long de la deuxième direction (D2),
l'électrode de seconde poutre opposée (32AE) inclut
une seconde portion d'extension opposée (32AEx) s'étendant le long de la première direction (D1), et
une seconde portion de connexion d'extension opposée (32AEc) connectant la seconde portion d'extension opposée (32AEx) à la seconde portion intermédiaire opposée (32Ac), la seconde portion de connexion d'extension opposée (32AEx) s'étendant le long de la deuxième direction (D2).

4. Capteur selon la revendication 3, dans lequel
l'électrode de seconde poutre (32E) inclut une pluralité de secondes portions d'extension (32Ex),
l'électrode de seconde poutre opposée (32AE) inclut une pluralité des secondes portions d'extension opposées (32AEx),
une certaine de la pluralité de secondes portions d'extension (32Ex) est prévue entre la seconde poutre (32) et une autre de la pluralité de secondes portions d'extension (32Ex),
la longueur de la certaine de la pluralité de secondes portions d'extension (32Ex) le long de la première direction est plus longue qu'une longueur de l'autre de la pluralité de secondes portions d'extension (32Ex) le long de la première direction (D1),
une certaine de la pluralité de secondes portions d'extension opposées (32AEx) est prévue entre la seconde poutre opposée (32A) et une autre de la pluralité de secondes portions d'extension opposées (32AEx), et
la longueur de la certaine de la pluralité de secondes portions d'extension opposée (32AEx) le long de la première direction (D1) est plus longue qu'une longueur de l'autre de la pluralité de secondes portions d'extension opposées (32AEx) le long de la première direction (D1).

5. Capteur selon l'une quelconque des revendications 2-4,
dans lequel l'électrode de première poutre (31E) et l'électrode de seconde poutre (32E) satisfont au moins à l'une des conditions suivantes : première condition, deuxième condition, troisième condition, quatrième condition, cinquième condition, sixième condition, septième condition ou huitième condition ;
dans la première condition, une seconde masse de l'électrode de seconde poutre (32E) est différente d'une première masse de l"électrode de première poutre (31E),
dans la deuxième condition, une seconde épaisseur de l'électrode de seconde poutre (32E) le long de la troisième direction (D3) est différente d'une première épaisseur de l'électrode de première poutre (31E) le long de la troisième direction (D3),
dans la troisième condition, au moins une portion d'un second matériau inclus dans l'électrode de seconde poutre (32E) est différente d'au moins une portion d'un premier matériau inclus dans l'électrode de première poutre (31E),
dans la quatrième condition, une seconde taille d'un second trou inclus dans l'électrode de seconde poutre (32E) est différente d'une première taille d'un premier trou inclus dans l'électrode de première poutre (31E),
dans la cinquième condition, une seconde densité des seconds trous est différente d'une première densité des premiers trous.
dans la sixième condition, un second nombre des seconds trous est différent d'un premier nombre des premiers trous,
dans la septième condition, une seconde forme du second trou est différente d'une première forme du premier trou, et
dans la huitième condition, une structure de seconde couche de l'électrode de seconde poutre (32E) est différente d'une structure de première couche de l'électrode de première poutre (31E).

6. Capteur selon la revendication 1, dans lequel
la section d'éléments (10E) inclut en outre une première électrode fixe (51E) et une première électrode fixe opposée (51AE) fixées à la base,
la première électrode fixe (51E) fait face à l'électrode de première poutre (31E),
la première électrode fixe opposée (51AE) fait face à l'électrode de première poutre opposée (31AE),
une direction allant de la première électrode fixe (51E) à l'électrode de première poutre (31E) est le long de la deuxième direction (D2), et
une direction de la première électrode fixe opposée (51AE) à l'électrode de première poutre opposée (31A) est le long de la deuxième direction (D2).

7. Capteur selon la revendication 6, comprenant en outre :
un dispositif de commande (70),
le dispositif de commande étant configuré pour appliquer un premier signal AC entre la première électrode fixe (51E) et l'électrode de première poutre (31E), et
le dispositif de commande (70) étant configuré pour détecter un premier signal généré entre la première électrode fixe opposée (51AE) et l'électrode de première poutre opposée (31AE).

8. Dispositif électronique, comprenant :
le capteur selon l'une quelconque des revendications 1-7 ; et
un dispositif de commande de circuit (170) configuré pour commander un circuit (180) sur la base d'un signal obtenu à partir du capteur.
